(19) Europäisches Patentamt
European Patent Office
Office européen des brevets

(11) **EP 3 888 887 B1**

(12) **EUROPÄISCHE PATENTSCHRIFT**

(45) Veröffentlichungstag und Bekanntmachung des Hinweises auf die Patenterteilung:
**16.11.2022 Patentblatt 2022/46**

(21) Anmeldenummer: **20020142.4**

(22) Anmeldetag: **31.03.2020**

(51) Internationale Patentklassifikation (IPC):
**B29C 64/124** (2017.01)   **B29C 64/264** (2017.01)
**B33Y 10/00** (2015.01)   **B33Y 30/00** (2015.01)
**G03F 7/00** (2006.01)   **G03F 7/20** (2006.01)

(52) Gemeinsame Patentklassifikation (CPC):
**B29C 64/124; B29C 64/264; B33Y 10/00; B33Y 30/00; G03F 7/0037; G03F 7/2053**

(54) **VERFAHREN UND VORRICHTUNG ZUR LITHOGRAPHIEBASIERTEN GENERATIVEN FERTIGUNG EINES DREIDIMENSIONALEN BAUTEILS**

METHOD AND APPARATUS FOR LITHOGRAPHY-BASED GENERATIVE PRODUCTION OF A THREE-DIMENSIONAL COMPONENT

PROCÉDÉ ET DISPOSITIF DE FABRICATION ADDITIVE PAR LITHOGRAPHIE D'UN COMPOSANT TRIDIMENSIONNEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**06.10.2021 Patentblatt 2021/40**

(73) Patentinhaber: **UpNano GmbH**
**1030 Wien (AT)**

(72) Erfinder: **Gruber, Peter**
**1140 Wien (AT)**

(74) Vertreter: **Keschmann, Marc**
**Haffner und Keschmann Patentanwälte GmbH**
**Schottengasse 3a**
**1010 Wien (AT)**

(56) Entgegenhaltungen:
**US-A1- 2003 013 047    US-A1- 2005 012 246**
**US-A1- 2014 029 081**

- **KAPLAN A ET AL: "ACOUSTO-OPTIC LENS WITH VERY FAST FOCUS SCANNING", OPTICS LETTERS, OPTICAL SOCIETY OF AMERICA, US, Bd. 26, Nr. 14, 15. Juli 2001 (2001-07-15) , Seiten 1078-1080, XP001103640, ISSN: 0146-9592**

**Beschreibung**

Die Erfindung betrifft ein Verfahren zur lithographiebasierten generativen Fertigung eines dreidimensionalen Bauteils gemäß des unabhängigen Anspruchs 1.

Die Erfindung betrifft weiters eine Vorrichtung zur lithographiebasierten generativen Fertigung eines dreidimensionalen Bauteils gemäß des unabhängigen Anspruchs 8.

Die Anmeldung US 2003/013047 A1 offenbart ein Verfahren gemäß des Oberbegriffs des Anspruchs 1.

Ein Verfahren zur Ausbildung eines Formkörpers, bei dem die Verfestigung eines photosensitiven Materials mittels Multiphotonenabsorption vorgenommen wird, ist beispielsweise aus der DE 10111422 A1 bekannt geworden. Dazu strahlt man mit einem fokussierten Laserstrahl in das Bad des photosensitiven Materials ein, wobei die Bestrahlungsbedingungen für einen die Verfestigung auslösenden Mehrphotonenabsorptionsprozess nur in unmittelbarer Umgebung des Fokus erfüllt sind, sodass man den Fokus des Strahls nach Maßgabe der Geometriedaten des herzustellenden Formkörpers innerhalb des Badvolumens zu den zu verfestigenden Stellen führt.

Am jeweiligen Fokuspunkt wird hierbei ein Volumenelement des Materials verfestigt, wobei benachbarte Volumenelemente aneinanderhaften und der Formkörper durch nacheinander erfolgendes Verfestigen von benachbarten Volumenelementen aufgebaut wird. Beim Aufbau des Formkörpers geht man schichtweise vor, d.h. es werden zuerst Volumenelemente einer ersten Schicht verfestigt, bevor Volumenelemente einer nächsten Schicht verfestigt werden.

Bestrahlungseinrichtungen für Multiphotonen-Absorptionsverfahren umfassen eine Optik zum Fokussieren eines Laserstrahls sowie eine Ablenkeinrichtung zum Ablenken des Laserstrahls. Die Ablenkeinrichtung ist hierbei ausgebildet, um den Strahl nacheinander auf Fokuspunkte innerhalb des Materials zu fokussieren, die in ein und derselben, senkrecht zur Einstrahlrichtung des Strahls in das Material verlaufenden Ebene liegen. In einem x,y,z-Koordinatensystem wird diese Ebene auch als x,y-Ebene bezeichnet. Die durch die Strahlablenkung in der x,y-Ebene entstandenen verfestigten Volumenelemente bilden eine Schicht des Formkörpers aus.

Für den Aufbau einer nächsten Schicht erfolgt eine Veränderung der Relativposition der Bestrahlungseinrichtung relativ zum Bauteil in der z-Richtung, welche einer Einstrahlrichtung des wenigstens einen Strahls in das Material entspricht und senkrecht zur x,y-Ebene verläuft. Durch die zumeist motorisch erfolgende Verstellung der Bestrahlungseinrichtung relativ zum Bauteil wird der Fokuspunkt der Bestrahlungseinrichtung in eine neue x,y-Ebene verlagert, welche in z-Richtung um die gewünschte Schichtdicke von der vorangehenden x,y-Ebene beabstandet ist.

Die beschriebene Vorgehensweise führt dazu, dass die verfestigten Volumenelemente lediglich an vorgegebenen Positionen innerhalb eines dreidimensionalen Rasters erzeugt werden können. Dies führt an gekrümmten Oberflächen des Bauteils jedoch zu einer gestuften Ausbildung, ähnlich der pixelartigen Darstellung einer gekrümmten Linie auf einem Bildschirm. Die Strukturierungsauflösung an der Oberfläche des Bauteils hängt hierbei von der Größe der verfestigten Volumenelemente und von der Schichtdicke ab. Um die Strukturierungsauflösung zu erhöhen, kann die Schichtdicke reduziert werden; dies führt jedoch zu einer deutlichen Erhöhung der Dauer des Bauprozesses, weil die Anzahl der Schichten erhöht werden muss.

Es hat bereits verschiedene Vorschläge gegeben, die Größe der verfestigten Volumenelemente in den Randbereichen eines Bauteils derart an die gewünschte Oberflächenform anzupassen, dass die Abweichung der tatsächlichen Oberfläche von der gewünschten Oberfläche minimiert wird. Beispielsweise offenbart die DE 1020171140241 A1 ein Verfahren, bei dem die Belichtungsdosis für die Herstellung von an die Oberfläche angrenzenden Volumenelementen nach einem definierten Muster variiert wird. Dies führt dazu, dass die in den Randabschnitten geschriebenen Volumenelemente unterschiedliche Ausdehnungen aufweisen und so zur gewünschten Oberflächenstrukturierung beitragen. Nachteilig ist bei einem solchen Verfahren jedoch, dass die bei einer Erhöhung der Belichtungsdosis ins Material eingestrahlte Energie zu einer thermischen Zerstörung des Materials und zur Blasenbildung führen kann. Weiters ist der Einstellbereich bei einem derartigen Verfahren sehr begrenzt. Die maximale Variation der Größe eines Volumenelements beträgt weniger als 20% der Ausgangsgröße.

Die Erfindung zielt daher darauf ab, ein Verfahren und eine Vorrichtung zur lithographiebasierten generativen Fertigung eines dreidimensionalen Bauteils dahingehend weiterzuentwickeln, dass gekrümmte und schräge Oberflächen des Bauteils mit hoher Formgenauigkeit ausgebildet werden und die oben genannten Nachteile vermieden werden können.

Zur Lösung dieser Aufgabe sieht die Erfindung bei einem Verfahren der eingangs genannten Art vor, dass der Fokuspunkt in einer z-Richtung verlagert wird, wobei die z-Richtung einer Einstrahlrichtung des wenigstens einen Strahls in das Material entspricht, wobei die Verlagerung des Fokuspunkts in der z-Richtung mittels wenigstens eines im Strahlengang angeordneten akustooptischen Deflektors erfolgt, in welchem eine Schallwelle erzeugt wird, deren Frequenz periodisch moduliert wird.

Durch die Anordnung wenigstens eines akustooptischen Deflektors im Strahlengang des von der Strahlungsquelle ausgesendeten Strahls kann der Fokuspunkt stufenlos und mit hoher Geschwindigkeit in z-Richtung verlagert werden. Dies erlaubt es, die Position eines Volumenelements in z-Richtung frei zu wählen und Volumenelemente daher auch außerhalb der durch das oben erwähnte Raster definierten Positionen anzuordnen, um auf diese Weise eine optimale Anpassung an die jeweils zu erzielende Oberflächenform zu erreichen. Die Verlagerung des Fokuspunkts in z-Richtung erfordert hierbei keine mechanische Verstellung der Bestrahlungseinrichtung relativ zum Bauteil und ist daher unabhängig vom Wechsel von einer ersten zu einer nächsten Schicht. Insbesondere gelingt die Verlagerung des Fokuspunkts in z-Richtung ohne bewegliche Teile, sondern alleine auf Grund der Wirkung des erwähnten akustooptischen Deflektors.

Ein akustooptischer Deflektor ist ein optisches Bauelement, das einfallendes Licht in Frequenz und Ausbreitungsrichtung oder Intensität beeinflusst. Hierzu wird in einem transparenten Festkörper mit Schallwellen ein optisches Gitter erzeugt, an dem der Lichtstrahl gebeugt und gleichzeitig in seiner Frequenz verschoben wird. Dies erzeugt eine Strahlablenkung, wobei der Ablenkungswinkel von den relativen Wellenlängen von Licht- und Ultraschallwellen im transparenten Festkörper abhängt.

Durch eine periodische Variation der Frequenz der im transparenten Festkörper erzeugten Schallwelle bildet sich ein sogenannter "Zylinderlinseneffekt" aus, welcher den einfallenden Lichtstrahl in gleicher Weise bündelt wie eine Zylinderlinse. Eine gezielte Steuerung der periodischen Frequenzmodulation erlaubt es, die Brennweite der Zylinderlinse und damit die Divergenz des aus dem akustooptischen Deflektor austretenden Strahls zu verändern. Der Strahl mit der solcherart eingestellten Divergenz wird durch eine Abbildungseinheit der Bestrahlungseinrichtung geleitet, in welcher der Strahl mittels eines Objektivs fokussiert in das Material eingestrahlt wird. Der Fokuspunkt des in das Material eingebrachten Strahls variiert hierbei in z-Richtung in Abhängigkeit von der Divergenz.

Eine bevorzugte Ausbildung sieht hierbei vor, dass die Frequenzmodulation der Schallwelle einen konstanten Schallwellenfrequenzgradienten aufweist. Dies begünstigt die Entstehung des sogenannten "Zylinderlinseneffekts". Ändert sich die Schallwellenfrequenz hingegen nicht linear, bilden sich Wellenfrontfehler aus.

Bevorzugt ist weiters vorgesehen, dass der Fokuspunkt durch eine Änderung des (konstanten)

Schallwellenfrequenzgradienten der Frequenzmodulation verlagert wird. Die Änderung des Schallwellenfrequenzgradienten kann beispielsweise durch eine Änderung der Bandbreite der Frequenzmodulation bei gleichbleibender Periodendauer der periodischen Modulation erreicht werden. Alternativ kann die Bandbreite konstant gehalten und die Änderung des Schallwellenfrequenzgradienten durch eine Veränderung der Periodendauer bewirkt werden.

Die Grundfrequenz der Schallwelle beträgt bei einem transparenten Festkörper aus z.B. $TeO_2$ bevorzugt 50 MHz oder mehr, insbesondere > 100 MHz, insbesondere 100-150 MHz. Die Grundfrequenz wird beispielsweise um mindestens ± 10 %, bevorzugt ± 20-30 %, moduliert. Im Falle einer Grundfrequenz von z.B. 110 MHz wird diese beispielsweise um ±25 MHz periodisch moduliert, d.h. die Bandbreite der Frequenzmodulation beträgt 50 MHz und die Frequenz der Schallwelle wird daher zwischen 85 MHz und 135 MHz periodisch moduliert. Wie bereits erwähnt, bestimmt die Änderung des Schallwellenfrequenzgradienten die Brennweite der Zylinderlinse, wobei die Modulationsfrequenz bevorzugt mindesten 100 kHz, insbesondere 0.1-10 MHz beträgt. Vorzugsweise werden wenigstens zwei akustooptische Deflektoren im Strahlengang hintereinander verwendet, wobei die wenigstens zwei akustooptischen Deflektoren bevorzugt eine im Wesentlichen senkrecht zueinander verlaufende Richtung der Strahlablenkung oder eine gleiche Orientierung der Strahlablenkung aufweisen.

Die Kombination von zwei bevorzugt unmittelbar senkrecht hintereinander angeordneten akustooptischen Deflektoren behebt den bei einem einzigen Deflektor sonst auftretenden Astigmatismus. Bei einer Anordnung von zwei akustooptischen Deflektoren in einer Ebene wird der mögliche Verstellweg des Fokuspunkts in z-Richtung verdoppelt. Gemäß einer weitere bevorzugten Ausführung können vier hintereinander angeordnete akustooptische Deflektoren vorgesehen sein, von denen die ersten beiden Deflektoren ein erstes Paar und die nachfolgenden beiden Deflektoren ein zweites Paar bilden. Die Deflektoren innerhalb eines Paars sind hierbei jeweils mit gleicher Orientierung der Strahlablenkung ausgebildet und die Deflektoren des ersten Paars weisen eine bezüglich der Deflektoren des zweiten Paars senkrecht verlaufende Richtung der Strahlablenkung auf.

Wie an sich bekannt, wird der Fokuspunkts bevorzugt auch in einer quer zur z-Richtung verlaufenden x-y-Ebene verlagert, wobei die Verlagerung in der x-y-Ebene mittels einer von dem wenigstens einen akustooptischen Deflektor verschiedenen Ablenkeinheit erfolgt. Die Ablenkeinheit ist hierbei mit Vorteil im Strahlengang zwischen dem wenigstens einen akustooptischen Deflektor und der Abbildungseinheit angeordnet. Die Ablenkungseinheit kann beispielsweise als Galvanometer-Scanner ausgebildet sein. Zur zweidimensionalen Strahlablenkung kann entweder ein Spiegel in zwei Richtungen ausgelenkt werden oder es werden zwei orthogonal drehbare stehende Spiegel nahe beieinander aufgestellt, über die der Strahl reflektiert wird. Die beiden Spiegel können von je einem Galvanometerantrieb oder Elektromotor angetrieben werden.

Bevorzugt wird das Bauteil schichtweise mit sich in der x-y-Ebene erstreckenden Schichten aufgebaut, wobei der Wechsel von einer Schicht zu einer nächsten Schicht die Veränderung der Relativposition der Bestrahlungseinrichtung relativ zum Bauteil in der z-Richtung umfasst. Durch die mechanische Verstellung der Relativposition der Bestrahlungseinrichtung relativ zum Bauteil erfolgt die Grobverstellung des Fokuspunkts in der z-Richtung, nämlich der Wechsel von einer zur nächsten Schicht. Für die Einstellung von Zwischenstufen in der z-Richtung, d.h. für die Feinpositionierung des Fokuspunkts in z-Richtung, wird der Fokuspunkt hingegen mittels des akustooptischen Deflektors positionsverändert.

Bevorzugt kann hierbei so vorgegangen werden, dass die Verlagerung des Fokuspunkts in z-Richtung mittels des akustooptischen Deflektors innerhalb der Schichtdicke einer Schicht erfolgt. Dabei können innerhalb einer Schicht auch mehrere in z-Richtung übereinander angeordnete Lagen von Volumenelementen hergestellt werden ohne dass eine mechanische Verstellung der Relativposition der Bestrahlungseinrichtung relativ zum Bauteil erfolgen muss.

Gemäß einer bevorzugten Anwendung der Erfindung wird der Fokuspunkt mittels des akustooptischen Deflektors in z-Richtung verlagert, um eine gekrümmte Außenkontur des Bauteils auszubilden. Alternativ oder ergänzend kann auch so vorgegangen werden, dass der Fokuspunkt mittels des akustooptischen Deflektors in z-Richtung verlagert wird, um eine relativ zur x,y-Ebene schräg verlaufende Außenkontur des Bauteils auszubilden. Die Verlagerung des Fokuspunkts in z-Richtung kann hierbei der Oberflächenform folgen, indem der Fokuspunkt im Randbereich des Bauteils jeweils in einem solchen Abstand von der Oberfläche des herzustellenden Bauteils positioniert wird, der dem Abstand des gedachten Mittelpunkts des zu verfestigenden Volumenelements zur Außenfläche des Volumenelements entspricht.

Eine bevorzugte Verfahrensweise ergibt sich, wenn das Material auf einem Materialträger, wie z.B. in einer Wanne, vorliegt, und die Bestrahlung des Materials von unten durch den für die Strahlung zumindest bereichsweise durchlässigen Materialträger erfolgt. Hierbei kann eine Bauplattform in Abstand vom Materialträger positioniert und das Bauteil durch Verfestigen von zwischen der Bauplattform und dem Materialträger befindlichem Material auf der Bauplattform aufgebaut werden. Alternativ ist es aber auch möglich, die Bestrahlung des Materials von oben vorzunehmen.

Die Strukturierung eines geeigneten Materials mittels Multiphotonenabsorption bietet den Vorteil einer überaus hohen Strukturauflösung, wobei Volumenelemente mit minimalen Strukturgrößen von bis zu 50nm x 50nm x 50nm erzielbar sind. Bedingt durch das kleine Fokuspunktvolumen ist der Durchsatz eines solchen Verfahrens allerdings sehr gering, da z.B. für ein Volumen von 1mm$^3$ insgesamt mehr als $10^9$ Punkte belichtet werden müssen. Dies führt zu sehr langen Bauzeiten, was der Hauptgrund für den geringen industriellen Einsatz von MultiphotonenabsorptionsVerfahren ist.

Um den Bauteiledurchsatz zu erhöhen ohne die Möglichkeit einer hohen Strukturauflösung zu verlieren, sieht eine bevorzugte Weiterentwicklung der Erfindung vor, dass das Volumen des Fokuspunkts während des Aufbaus des Bauteils zumindest einmal variiert wird, sodass das Bauteil aus verfestigten Volumenelementen unterschiedlichen Volumens aufgebaut wird.

Durch das variable Volumen des Fokuspunktes sind (bei kleinem Fokuspunktvolumen) hohe Auflösungen möglich. Gleichzeitig ist (bei großem Fokuspunktvolumen) eine hohe Schreibgeschwindigkeit (gemessen in mm$^3$/h) erzielbar. Durch das Variieren des Fokuspunktvolumens kann also eine hohe Auflösung mit großem Durchsatz kombiniert werden. Die Variation des Fokuspunktvolumens kann dabei zum Beispiel so genutzt werden, dass im Inneren des aufzubauenden Bauteils ein großes Fokuspunktvolumen verwendet wird, um den Durchsatz zu erhöhen, und an der Oberfläche des Bauteils ein kleineres Fokuspunktvolumen zur Anwendung kommt, um die Bauteiloberfläche mit hoher Auflösung auszubilden. Eine Vergrößerung des Fokuspunktvolumens ermöglicht einen höheren Strukturierungsdurchsatz, da das in einem Belichtungsvorgang verfestigte Materialvolumen vergrößert wird. Um bei hohem Durchsatz eine hohe Auflösung beizubehalten, können kleine Fokuspunktvolumina für feinere Strukturen und Oberflächen, und größere Fokuspunktvolumina für grobe Strukturen und/oder zum Füllen von Innenräumen verwendet werden. Verfahren und Vorrichtungen zur Veränderung des Fokuspunktvolumens sind in der WO 2018/006108 A1 beschrieben.

Im Rahmen der vorliegenden Erfindung kann die Bauzeit erheblich verkürzt werden, wenn die im Bauteilinneren befindlichen Schichten mit hoher Schichtdicke und daher mit großvolumigen Volumenelementen aufgebaut und die Randbereiche aus kleinvolumigen Volumenelementen erstellt werden und in den Randbereichen zusätzlich eine individuelle Anpassung der Position der Volumenelemente entlang der z-Richtung erfolgt, um an der Oberfläche eine hohe Strukturauflösung zu erhalten.

Bei einer bevorzugten Verfahrensweise erfolgt die Variation des Fokusvolumens derart, dass das Volumenverhältnis zwischen dem größten Fokuspunktvolumen während der Fertigung eines Bauteils und dem kleinsten Fokuspunktvolumen mindestens 2, bevorzugt mindestens 5 beträgt.

Das Prinzip der Multiphotonenabsorption wird im Rahmen der Erfindung genutzt, um im photosensitiven Materialbad einen photochemischen Vorgang zu initiieren. Multiphotonenabsorptionsverfahren umfassen beispielsweise auch Verfahren der 2-Photonenabsorption. Als Folge der photochemischen Reaktion kommt es zur Veränderung des Materials in mindestens einen anderen Zustand, wobei es typischerweise zu einer Photopolymerisation kommt. Das Prinzip der Multiphotonenabsorption beruht darauf, dass der genannte photochemische Vorgang nur in jenen Bereichen des Strahlengangs stattfindet, in denen eine für die Multiphotonenabsorption ausreichende Photonendichte vorliegt. Die höchste Photonendichte tritt im Brennpunkt des optischen Abbildungssystems auf, sodass die Multiphotonenabsorption mit ausreichender Wahrscheinlichkeit nur im Fokuspunkt auftritt. Außerhalb des Brennpunktes ist die Photonendichte geringer, sodass die Wahrscheinlichkeit der Multiphotonenabsorption außerhalb des Brennpunktes zu gering ist, um eine unumkehrbare Veränderung des Materials durch eine photochemische Reaktion zu bewirken. Die elektromagnetische Strahlung kann in der verwendeten Wellenlänge weitestgehend ungehindert das Material passieren und nur im Fokuspunkt kommt es zu einer Interaktion zwischen photosensitivem Material und elektromagnetischer Strahlung. Das Prinzip der Multiphotonenabsorption ist beispielsweise in Zipfel et al, "Nonlinear magic: multiphoton microscopy in the biosciences", NATURE BIOTECHNOLOGY VOLUME 21 NUMBER 11 NOVEMBER 2003, beschrieben.

Als Quelle für die elektromagnetische Strahlung kann es sich vorzugsweise um einen kollimierten Laserstrahl handeln. Der Laser kann sowohl eine oder mehrere, feste oder variable Wellenlängen emittieren. Insbesondere handelt es sich um einen kontinuierlichen oder gepulsten Laser mit Pulslängen im Nanosekunden-, Pikosekunden- oder Femtosekunden-Bereich. Ein gepulster Femtosekundenlaser bietet dabei den Vorteil, dass eine geringere mittlere Leistung für die Multiphotonenabsorption benötigt wird.

Unter photosensitivem Material wird jedes unter Baubedingungen fließfähige oder feste Material verstanden, das durch Multiphotonenabsorption im Fokuspunktvolumen in einen zweiten Zustand übergeht - beispielsweise durch Polymerisation. Die Materialveränderung muss sich dabei auf das Fokuspunktvolumen und dessen direkte Umgebung begrenzen. Die Veränderung der Substanzeigenschaften kann dauerhaft sein und beispielsweise in einer Veränderung von einem flüssigen in einen festen Zustand bestehen, kann jedoch auch nur vorübergehend sein. Auch eine dauerhafte Veränderung kann im Übrigen reversibel oder nicht reversibel sein. Die Änderung der Materialeigenschaften muss nicht zwingend vollständig von einem in den anderen Zustand übergehen, sondern kann auch als Mischform beider Zustände vorliegen.

Die Leistung der elektromagnetischen Strahlung und die Belichtungsdauer beeinflussen die Qualität des erzeugten Bauteils. Durch Anpassung der Strahlungsleistung und/oder der Belichtungsdauer kann das Volumen des Fokuspunktes in einem engen Bereich variiert werden. Bei zu hohen Strahlungsleistungen treten zusätzliche Prozesse auf, die zur Beschädigung des Bauteils führen können. Ist die Strahlungsleistung zu gering, kann sich keine dauerhafte Materialeigenschaftsänderung einstellen. Für jedes photosensitive Material gibt es daher typische Bauprozessparameter die mit guten Bauteileigenschaften verbunden sind.

Bevorzugt ist vorgesehen, dass die Änderung des Fokuspunktvolumens in wenigstens einer, bevorzugt zwei, insbesondere in drei, senkrecht zueinander stehenden Raumrichtungen erfolgt.

Gemäß einem zweiten Aspekt der Erfindung wird eine Vorrichtung zur lithographiebasierten generativen Fertigung eines dreidimensionalen Bauteils, insbesondere zur Durchführung eines Verfahrens gemäß dem ersten Aspekt der Erfindung, bereitgestellt, umfassend einen Materialträger für ein verfestigbares Material und eine Bestrahlungseinrichtung, die zur ortsselektiven Bestrahlung des verfestigbaren Materials mit wenigstens einem Strahl ansteuerbar ist, wobei die Bestrahlungseinrichtung eine optische Ablenkeinheit umfasst, um den wenigstens einen Strahl nacheinander auf Fokuspunkte innerhalb des Materials zu fokussieren, wodurch jeweils ein am Fokuspunkt befindliches Volumenelement des Materials mittels Multiphotonenabsorption verfestigbar ist, dadurch gekennzeichnet, dass die Bestrahlungseinrichtung wenigstens einen im Strahlengang des Strahls angeordneten akustooptischen Deflektor umfasst, welcher zur Verlagerung des Fokuspunkts in einer z-Richtung ausgebildet ist, wobei die z-Richtung einer Einstrahlrichtung des wenigstens einen Strahls in das Material entspricht.

Bevorzugt umfasst die Steuerung des wenigstens einen akustooptischen Deflektors einen Frequenzgenerator, der zur periodischen Modulation der Ultraschallfrequenz ausgebildet ist.

Bevorzugt ist hierbei vorgesehen, dass der Frequenzgenerator ausgebildet ist, um den Schallwellenfrequenzgradienten zu verändern.

Wie bereits im Zusammenhang mit dem erfindungsgemäßen Verfahren erwähnt, ist es vorteilhaft, wenn wenigstens zwei akustooptische Deflektoren im Strahlengang hintereinander angeordnet sind, wobei die wenigstens zwei akustooptischen Deflektoren bevorzugt eine im Wesentlichen senkrecht zueinander verlaufende Richtung der Strahlablenkung oder eine gleiche Orientierung der Strahlablenkung aufweisen.

Weiters ist die Ablenkeinheit bevorzugt ausgebildet, um den Fokuspunkt in einer quer zur z-Richtung verlaufenden x-y-Ebene zu verlagern.

Insbesondere kann die Bestrahlungseinrichtung ausgebildet sein, um das Bauteil schichtweise mit sich in der x-y-Ebene erstreckenden Schichten aufzubauen, wobei der Wechsel von einer Schicht zu einer nächsten Schicht die Veränderung der Relativposition der Bestrahlungseinrichtung relativ zum Bauteil in der z-Richtung umfasst.

Die Bestrahlungseinrichtung ist bevorzugt derart ausgebildet, dass die Verlagerung des Fokuspunkts in z-Richtung mittels des akustooptischen Deflektors innerhalb der Schichtdicke einer Schicht erfolgt.

Weiters kann vorgesehen sein, dass das Material auf einem Materialträger, wie z.B. in einer Wanne, vorliegt, und die Bestrahlung des Materials von unten durch den für die Strahlung zumindest bereichsweise durchlässigen Materialträger erfolgt.

Die Bauplattform wird hierbei bevorzugt in Abstand vom Materialträger positioniert und das Bauteil durch Verfestigen von zwischen der Bauplattform und dem Materialträger befindlichen Volumenelementen auf der Bauplattform aufgebaut.

Dabei ist es vorteilhaft, wenn das Volumen des Fokuspunkts während des Aufbaus des Bauteils zumindest einmal variiert wird, sodass das Bauteil aus verfestigten Volumenelementen unterschiedlichen Volumens aufgebaut wird.

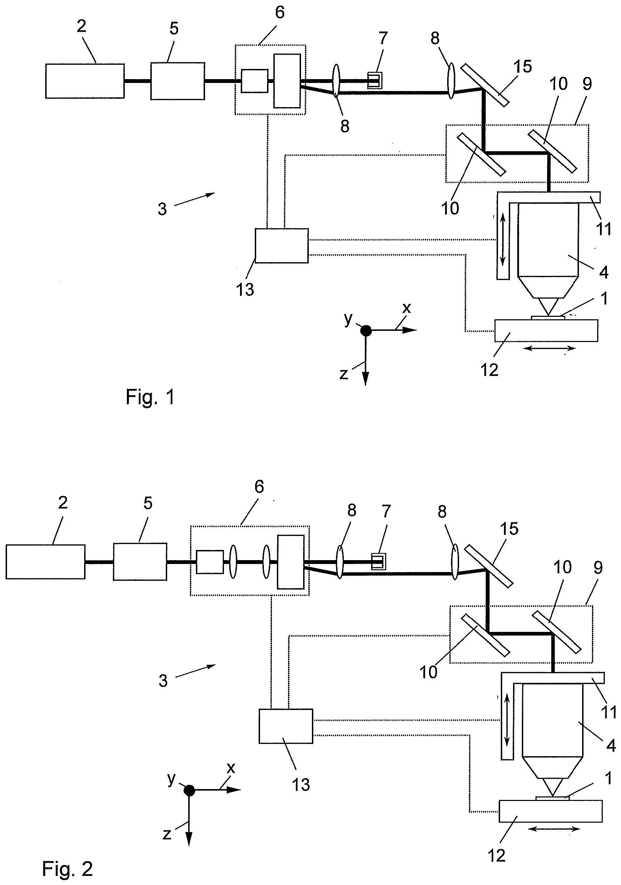

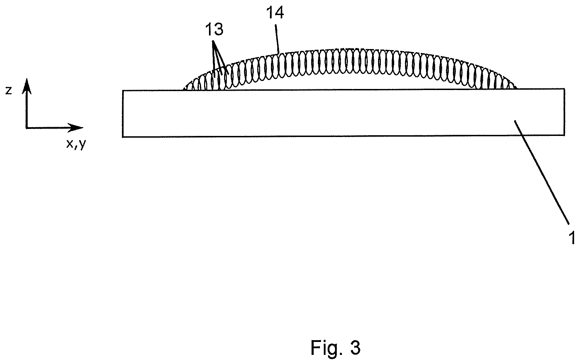

Die Erfindung wird nachfolgend anhand von in der Zeichnung schematisch dargestellten Ausführungsbeispielen näher erläutert. In dieser zeigen Fig. 1 eine schematische Darstellung einer erfindungsgemäßen Vorrichtung, Fig. 2 eine abgewandelte Ausführungsform der Vorrichtung gemäß Fig. 1 und Fig. 3 eine schematische Darstellung der Anordnung von Volumenelementen im Randbereich eines Bauteils.

In Fig. 1 ist ein Substrat bzw. Träger mit 1 bezeichnet, auf welchem ein Bauteil aufgebaut werden soll. Das Substrat ist in einer nicht dargestellten Materialwanne angeordnet, welche mit einem photopolymerisierbaren Material gefüllt ist. In das Material wird ein von einer Strahlungsquelle 2 ausgesendeter Laserstrahl mittels einer Bestrahlungseinrichtung 3 nacheinander auf Fokuspunkte innerhalb des photopolymerisierbaren Materials fokussiert, wodurch jeweils ein am Fokuspunkt befindliches Volumenelement des Materials mittels Multiphotonenabsorption verfestigt wird. Die Bestrahlungseinrichtung umfasst zu diesem Zweck eine Abbildungseinheit umfassend ein Objektiv 4, welches den Laserstrahl innerhalb eines Schreibbereichs in das Material einbringt.

Der Laserstrahl gelangt von der Strahlungsquelle 2 zunächst in einen Pulskompressor 5 und wird danach durch wenigstens ein akustooptisches Deflektormodul 6 geleitet, dessen zwei akustooptische Deflektoren den Strahl in einen Strahl nullter Ordnung und einen Strahl erster Ordnung aufteilen. Der Strahl nullter Ordnung wird in einer Strahlfalle 7 aufgefangen. Das akustooptische Deflektormodul 6 umfasst hierbei zwei hintereinander angeordnete akustooptische Deflektoren, deren Richtung der Strahlablenkung senkrecht zueinander verläuft. Hinsichtlich des abgelenkten Strahls erster Ordnung wirkt das akustooptische Deflektormodul 6 jeweils als Zylinderlinse mit einstellbarer Brennweite, sodass der Strahl erster Ordnung eine einstellbare Divergenz aufweist. Der Strahl erster Ordnung wird nun über Relaislinsen 8 und einen Umlenkspiegel 15 in eine Ablenkeinheit 9 geführt, in dem der Strahl nacheinander an zwei Spiegeln 10 reflektiert wird. Die Spiegel 10 sind um Drehachsen schwenkbar angetrieben, die zueinander orthogonal verlaufen, sodass der Strahl sowohl in der x-als auch in der y-Achse ausgelenkt werden kann. Die beiden Spiegel 10 können von je einem Galvanometerantrieb oder Elektromotor angetrieben werden. Der aus der Ablenkeinheit 9 austretende Strahl gelangt bevorzugt über ein nicht dargestelltes Relais-Linsensystem in das Objektiv, welches den Strahl wie bereits erwähnt in das photopolymerisierbare Material fokussiert.

Um das Bauteil schichtweise aufzubauen, werden im Material Volumenelemente einer Schicht nach der anderen verfestigt. Zum Aufbau einer ersten Schicht wird der Laserstrahl nacheinander auf Fokuspunkte, die in der Fokusebene des Objektivs 4 angeordnet sind, innerhalb des Materials fokussiert. Die Ablenkung des Strahls in der x,y-Ebene erfolgt hierbei mit Hilfe der Ablenkeinheit 9, wobei der Schreibbereich durch das Objektiv 4 begrenzt ist. Für den Wechsel in die nächste Ebene wird das an einem Träger 11 befestigte Objektiv 4 in z-Richtung relativ zum Substrat 1 um den Schichtlagenabstand verstellt, welcher der Schichtdicke entspricht. Alternativ kann auch das Substrat 1 relativ zum feststehenden Objektiv 4 verstellt werden.

Wenn das herzustellende Bauteil in x- und/oder y-Richtung größer ist als der Schreibbereich des Objektivs 4, werden Teilstrukturen des Bauteils nebeneinander aufgebaut (sog. Stitching). Dazu ist das Substrat 1 auf einem Kreuztisch 12 angeordnet, der in x- und/oder y-Richtung relativ zur Bestrahlungseinrichtung 3 verschiebbar ist.

Weiters ist eine Steuerung 12 vorgesehen, welche den wenigstens einen akustooptischen Deflektor 6, die Ablenkeinrichtung 9, den Träger 11 und den Kreuztisch 12 ansteuert.

Der akustooptische Deflektor 6 bildet einen Zylinderlinseneffekt aus, der vom Schallwellenfrequenzgradienten der Frequenzmodulation abhängt. Die äquivalente Brennweite der Zylinderlinse $F_l$ kann hierbei wie folgt berechnet werden:

$$F_l = \frac{v_a{}^2}{\lambda \frac{dF_a}{dt}}$$

wobei $v_a$ die akustische Ausbreitungsgeschwindigkeit im Kristall, $\lambda$ die Wellenlänge des Laserstrahls und $dF_a/dt$ der Schallwellenfrequenzgradient im Kristall darstellt. In TeO$_2$ mit einer Ausbreitungsgeschwindigkeit von 4200 m/s bei einer Wellenlänge des Lasers von 780 nm und dem Durchlaufen einer Bandbreite von $\pm 25$ MHz (z.B. ausgehend von einer Grundanregungsfrequenz von 110 MHz) innerhalb von 0,2 ps ergibt sich eine Brennweite der akustooptischen Zylinderlinse von 90 mm. Bei einem Objektiv 4 mit einer Brennweite von 9 mm und einer 20x Aufweitung ergibt sich dadurch eine neue Brennweite des Gesamtsystems von

$$F_{total} = \frac{F_{Obj}\, F_l}{F_{Obj} + F_l}$$

was bei den oben erwähnten Parametern eine Verschiebung in z-Richtung, je nach Vorzeichen des Gradienten, von $\pm 90\ \mu$m. entspricht. Durch Veränderung des Schallwellenfrequenzgradienten kann die z-Position des Volumenelements linear und stufenfrei eingestellt werden.

Die beschriebene Möglichkeit zur stufenlosen Verstellung des Fokuspunkts in z-Richtung kann erfindungsgemäß ausgenutzt werden, um eine schräge oder gekrümmte Oberfläche optimal anzunähern, wie dies in Fig. 3 schematisch dargestellt ist. In Fig. 3 sind die einzelnen Volumenelemente mit 13 bezeichnet und die gekrümmte Oberfläche des Bauteils ist mit 14 bezeichnet. Es ist erkennbar, dass die z-Position der Volumenelemente 13 der Oberflächenform nachgeführt ist, wobei die Größe der einzelnen Volumenelemente 13 gleichbleiben kann.

In Fig. 2 ist eine abgewandelte Ausführungsform der Vorrichtung gemäß Fig. 1 dargestellt, bei welcher das akustooptische Deflektormodul 6 im Unterschied zu Fig. 1 zwei akustooptische Deflektoren aufweist, zwischen denen Relais-Linsen angeordnet sind, um sicherzustellen, dass der Fokuspunkt am Ein- und am Ausgang des akustooptische Deflektormoduls 6 auf selber Linie angeordnet sind.

**Patentansprüche**

1. Verfahren zur lithographiebasierten generativen Fertigung eines dreidimensionalen Bauteils, bei dem wenigstens ein von einer elektromagnetischen Strahlungsquelle (2) ausgesendeter Strahl mittels einer Bestrahlungseinrichtung (3) nacheinander auf Fokuspunkte innerhalb eines Materials fokussiert wird, wodurch jeweils ein am Fokuspunkt befindliches Volumenelement (13) des Materials mittels Multiphotonenabsorption verfestigt wird, wobei der Fokuspunkt in einer z-Richtung verlagert wird, wobei die z-Richtung einer Einstrahlrichtung des wenigstens einen Strahls in das Material entspricht, **gekennzeichnet dadurch, dass** die Verlagerung des Fokuspunkts in der z-Richtung mittels wenigstens eines im Strahlengang angeordneten akustooptischen Deflektors (6) erfolgt, in welchem eine Schallwelle erzeugt wird, deren Frequenz periodisch moduliert wird.

2. Verfahren nach Anspruch 1, **dadurch gekennzeichnet, dass** der Fokuspunkt durch eine Änderung des Schallwellenfrequenzgradienten der Frequenzmodulation verlagert wird.

3. Verfahren nach Anspruch 1 oder 2, **dadurch gekennzeichnet, dass** wenigstens zwei akustooptische Deflektoren (6) im Strahlengang hintereinander verwendet werden, wobei die wenigstens zwei akustooptischen Deflektoren (6) bevorzugt eine im Wesentlichen senkrecht zueinander verlaufende Richtung der Strahlablenkung oder eine gleiche Orientierung der Strahlablenkung aufweisen.

4. Verfahren nach Anspruch 1, 2 oder 3, **dadurch gekennzeichnet, dass** der Fokuspunkts in einer quer zur z-Richtung verlaufenden x-y-Ebene verlagert wird, wobei die Verlagerung in der x-y-Ebene mittels einer von dem wenigstens einen akustooptischen Deflektor (6) verschiedenen Ablenkeinheit (9) erfolgt.

5. Verfahren nach einem der Ansprüche 1 bis 4, **dadurch gekennzeichnet, dass** das Bauteil schichtweise mit sich in der x-y-Ebene erstreckenden Schichten aufgebaut wird, wobei der Wechsel von einer Schicht zu einer nächsten Schicht die Veränderung der Relativposition der Bestrahlungseinrichtung (3) relativ zum Bauteil in der z-Richtung umfasst.

6. Verfahren nach Anspruch 5, **dadurch gekennzeichnet, dass** die Verlagerung des Fokuspunkts in z-Richtung mittels des akustooptischen Deflektors (6) innerhalb der Schichtdicke einer Schicht erfolgt.

7. Verfahren nach einem der Ansprüche 1 bis 6, **dadurch gekennzeichnet, dass** der Fokuspunkt mittels des akustooptischen Deflektors (6) in z-Richtung verlagert wird, um eine gekrümmte Außenkontur oder eine relativ zur x,y-Ebene schräg verlaufende Außenkontur des Bauteils auszubilden, wobei die Größe der die Außenkontur ausbildenden Volumenelemente (13) bevorzugt gleich gewählt ist.

8. Vorrichtung zur lithographiebasierten generativen Fertigung eines dreidimensionalen Bauteils, insbesondere zur Durchführung eines Verfahrens nach einem der Ansprüche 1 bis 7, umfassend einen Materialträger (1) für ein verfestigbares Material und eine Bestrahlungseinrichtung (3), die zur ortsselektiven Bestrahlung des verfestigbaren Materials mit wenigstens einem Strahl ansteuerbar ist, wobei die Bestrahlungseinrichtung (3) eine optische Ablenkeinheit (9) umfasst, um den wenigstens einen Strahl nacheinander auf Fokuspunkte innerhalb des Materials zu fokussieren, wodurch jeweils ein am Fokuspunkt befindliches Volumenelement (13) des Materials mittels Multiphotonenabsorption verfestigbar ist, wobei die Bestrahlungseinrichtung (3) wenigstens einen im Strahlengang des Strahls angeordneten akustooptischen Deflektor (6) umfasst, welcher zur Verlagerung des Fokuspunkts in einer z-Richtung ausgebildet ist, wobei die z-Richtung einer Einstrahlrichtung des wenigstens einen Strahls in das Material entspricht.

9. Vorrichtung nach Anspruch 8, **dadurch gekennzeichnet, dass** der wenigstens eine akustooptische Deflektor (6) einen Frequenzgenerator umfasst, der zur periodischen Modulation der Ultraschallfrequenz ausgebildet ist.

10. Vorrichtung nach Anspruch 8 oder 9, **dadurch gekennzeichnet, dass** der Frequenzgenerator ausgebildet ist, um den Schallwellenfrequenzgradienten zu verändern.

11. Vorrichtung nach Anspruch 8, 9 oder 10, **dadurch gekennzeichnet, dass** wenigstens zwei akustooptische Deflektoren (6) im Strahlengang hintereinander angeordnet sind, wobei die wenigstens zwei akustooptischen Deflektoren (6) bevorzugt eine im Wesentlichen senkrecht zueinander verlaufende Richtung der Strahlablenkung oder eine gleiche Orientierung der Strahlablenkung aufweisen.

12. Vorrichtung nach einem der Ansprüche 8 bis 11, **dadurch gekennzeichnet, dass** die Ablenkeinheit (9) ausgebildet ist, um den Fokuspunkt in einer quer zur z-Richtung verlaufenden x-y-Ebene zu verlagern.

13. Vorrichtung nach einem der Ansprüche 8 bis 12, **dadurch gekennzeichnet, dass** die Bestrahlungseinrichtung (3) ausgebildet ist, um das Bauteil schichtweise mit sich in der x-y-Ebene erstreckenden Schichten aufzubauen, wobei der Wechsel von einer Schicht zu einer nächsten Schicht die Veränderung der Relativposition der Bestrahlungseinrichtung (3) relativ zum Bauteil in der z-Richtung umfasst.

14. Vorrichtung nach einem der Ansprüche 8 bis 13, **dadurch gekennzeichnet, dass** die Bestrahlungseinrichtung (3) derart ausgebildet ist, dass die Verlagerung des Fokuspunkts in z-Richtung mittels des akustooptischen Deflektors (6) innerhalb der Schichtdicke einer Schicht erfolgt.

## Claims

1. Method for the lithography-based generative manufacturing of a three-dimensional component, in which at least one beam emitted by an electromagnetic radiation source (2) is successively focused by means of an irradiation device (3) onto focal points within a material, as a result of which in each case a volume element (13) of the material located at the focal point is solidified by means of multiphoton absorption, wherein the focal point is displaced in a z-direction, the z-direction corresponding to a direction of irradiation of the at least one beam into the material, **characterized in that** the displacement of the focal point in the z-direction being effected by means of at least one acousto-optical deflector (6) arranged in the beam path, in which a sound wave is generated, the frequency of which is periodically modulated.

2. The method according to claim 1, **characterized in that** the focal point is displaced by changing the sound wave frequency gradient of the frequency modulation.

3. The method according to claim 1 or 2, **characterized in that** at least two acousto-optical deflectors (6) are used one behind the other in the beam path, the at least two acousto-optical deflectors (6) preferably having a direction of beam deflection which is substantially perpendicular to one another or having the same orientation of beam deflection.

4. The method according to claim 1, 2 or 3, **characterized in that** the focal point is displaced in an x-y plane extending transversely to the z-direction, the displacement in the x-y plane being effected by means of a deflection unit (9) different from the at least one acousto-optical deflector (6).

5. The method according to any one of claims 1 to 4, **characterized in that** the component is built up layer by layer with layers extending in the x-y plane, the change from one layer to a next layer comprising the change of the relative position of the irradiation device (3) relative to the component in the z-direction.

6. The method according to claim 5, **characterized in that** the displacement of the focal point in the z-direction by means of the acousto-optical deflector (6) takes place within the layer thickness of a layer.

7. The method according to any one of claims 1 to 6, **characterized in that** the focal point is displaced in the z-direction by means of the acousto-optical deflector (6) in order to form a curved outer contour or an outer contour of the component which is oblique relative to the x,y-plane, the size of the volume elements (15) forming the outer contour preferably being selected to be equal.

8. Apparatus for the lithography-based generative manufacturing of a three-dimensional component, in particular for carrying out a method according to any one of claims 1 to 7, comprising a material carrier (1) for a solidifiable material and an irradiation device (3) which can be controlled for the position-selective irradiation of the solidifiable material with at least one beam, the irradiation device (3) comprising an optical deflection unit (9), in order to focus the at least one beam successively onto focal points within the material, whereby in each case a volume element (13) of the material located at the focal point can be solidified by means of multiphoton absorption, wherein the irradiation device (3) comprises at least one acousto-optical deflector (6) which is arranged in the beam path of the beam and is designed to displace the focal point in a z-direction, the z-direction corresponding to an irradiation direction of the at least one beam into the material.

9. The apparatus according to claim 8, **characterized in that** the at least one acousto-optic deflector (6) comprises a frequency generator adapted to periodically modulate the sound wave frequency.

10. The apparatus according to claim 8 or 9, **characterized in that** the frequency generator is adapted to vary the sound wave frequency gradient.

**11.** The apparatus according to claim 8, 9 or 10, **characterized in that** at least two acousto-optical deflectors (6) are arranged one behind the other in the beam path, the at least two acousto-optical deflectors (6) preferably having a direction of beam deflection extending substantially perpendicular to one another or having the same orientation of beam deflection.

**12.** The apparatus according to any one of claims 8 to 11, **characterized in that** the deflection unit (9) is designed to displace the focal point in an x-y plane extending transversely to the z-direction.

**13.** The apparatus according to any one of claims 8 to 12, **characterized in that** the irradiation device (3) is adapted to build up the component layer by layer with layers extending in the x-y plane, the change from one layer to a next layer comprising changing the relative position of the irradiation device (3) relative to the component in the z-direction.

**14.** The apparatus according to any one of claims 8 to 13, **characterized in that** the irradiation device (3) is designed in such a way that the displacement of the focal point in the z-direction by means of the acousto-optical deflector (6) takes place within the layer thickness of a layer.


**Revendications**

**1.** Procédé de fabrication générative par lithographie d'un composant tridimensionnel, dans lequel au moins un faisceau émis par une source de rayonnement électromagnétique (2) est successivement focalisé au moyen d'un dispositif d'irradiation (3) sur des points de focalisation à l'intérieur d'un matériau, par lequel un élément volumique (13) du matériau situé au point de focalisation est solidifié par absorption multiphotonique, le point de focalisation est déplacé dans une direction z, la direction z correspondant à une direction d'entrée de l'au moins un faisceau dans le matériau, **caractérisé en ce que** le point de focalisation est déplacé dans la direction z au moyen d'au moins un déflecteur acousto-optique (6) disposé dans le trajet du faisceau, dans lequel une onde sonore est générée dont la fréquence est périodiquement modulée.

**2.** Procédé selon la revendication 1, **caractérisé en ce que** le point de focalisation est déplacé en modifiant le gradient de fréquence d'onde sonore de la modulation de fréquence.

**3.** Procédé selon la revendication 1 ou 2, **caractérisé en ce qu'**au moins deux déflecteurs acousto-optiques (6) sont utilisés l'un derrière l'autre dans le trajet du faisceau, les au moins deux déflecteurs acousto-optiques (6) ayant de préférence des directions de déviation du faisceau essentiellement perpendiculaires l'une à l'autre, ou une orientation de déviation du faisceau identique.

**4.** Procédé selon la revendication 1, 2 ou 3, **caractérisé en ce que** le point de focalisation est déplacé dans un plan x-y s'étendant transversalement à la direction z, le déplacement dans le plan x-y étant effectué au moyen d'une unité de déviation (9) différente de l'au moins un déflecteur acousto-optique (6).

**5.** Procédé selon l'une des revendications 1 à 4, **caractérisé en ce que** le composant est formé en couches avec des couches s'étendant dans le plan x-y, le passage d'une couche à une couche suivante comprenant la modification de la position relative du dispositif d'irradiation par rapport au composant dans la direction z.

**6.** Procédé selon la revendication 5, **caractérisé en ce que** le déplacement du point de focalisation dans la direction z au moyen du déflecteur acousto-optique (6) est effectué à l'intérieur de l'épaisseur d'une couche.

**7.** Procédé selon l'une des revendications 1 à 6, **caractérisé en ce que** le point de focalisation est déplacé dans la direction z au moyen du déflecteur acousto-optique (6) pour former un contour extérieur courbe, ou un contour extérieur qui s'étend obliquement par rapport au plan x-y, du composant, la taille des éléments de volume (13) formant le contour extérieur étant de préférence choisie identique.

**8.** Dispositif pour la fabrication générative par lithographie d'un composant tridimensionnel, en particulier pour la mise en oeuvre d'un procédé selon l'une des revendications 1 à 7, comprenant un support de matériau (1) pour un matériau solidifiable et un dispositif d'irradiation (3) qui peut être contrôlé pour l'irradiation de manière localement sélective du matériau solidifiable avec au moins un faisceau, le dispositif d'irradiation (3) comprenant une unité de déviation optique (9) afin de focaliser successivement l'au moins un faisceau sur des points de focalisation à l'intérieur du matériau, par lequel un élément de volume (13) du matériau situé au point de focalisation peut être solidifié par absorption multiphotonique, le dispositif d'irradiation (3) comprenant au moins un déflecteur acousto-optique (6) disposé dans le trajet du faisceau, qui est conçu pour déplacer le point de focalisation dans une direction z, la direction z correspondant à une direction d'entrée de l'au moins un faisceau dans le matériau.

**9.** Dispositif selon la revendication 8, **caractérisé en ce que** le au moins un déflecteur acousto-optique (6) comprend un générateur de fréquence qui est conçu pour la modulation périodique de la fréquence ultrasonore.

**10.** Dispositif selon la revendication 8 ou 9, **caractérisé en ce que** le générateur de fréquence est conçu pour modifier le gradient de fréquence d'onde sonore.

**11.** Dispositif selon la revendication 8, 9 ou 10, **caractérisé en ce qu'**au moins deux déflecteurs acousto-optiques (6) sont disposés l'un derrière l'autre dans le trajet du faisceau, les au moins deux déflecteurs acousto-optiques (6) ayant de préférence des directions de déviation du faisceau essentiellement perpendiculaires l'une à l'autre, ou une orientation de déviation du faisceau identique.

**12.** Dispositif selon l'une des revendications 8 à 11, **caractérisé en ce que** l'unité de déviation (9) est conçue pour déplacer le point de focalisation dans un plan x-y s'étendant transversalement à la direction z.

**13.** Dispositif selon l'une des revendications 8 à 12, **caractérisé en ce que** le dispositif d'irradiation (3) est conçu pour former le composant en couches avec des couches s'étendant dans le plan x-y,
le passage d'une couche à une couche suivante comprenant la modification de la position relative du dispositif d'irradiation par rapport au composant dans la direction z.

**14.** Dispositif selon l'une des revendications 8 à 13, **caractérisé en ce que** le dispositif d'irradiation (3) est conçu de telle sorte que le déplacement du point de focalisation dans la direction z au moyen du déflecteur acousto-optique (6) est effectué à l'intérieur de l'épaisseur d'une couche.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2003013047 A1
- DE 10111422 A1
- DE 1020171140241 A1
- WO 2018006108 A1

**In der Beschreibung aufgeführte Nicht-Patentliteratur**

- **ZIPFEL et al.** Nonlinear magic: multiphoton microscopy in the biosciences. *NATURE BIOTECHNOLOGY,* November 2003, vol. 21 (11